# EUROPEAN PATENT APPLICATION

(11) **EP 4 769 490 A1**
(43) Date of publication of application: **01.07.2026**
(21) Application number: 25769346.5
(22) Date of filing: 07.03.2025
(51) Int. Cl.: H01L 23/64, H10N 97/00, H01G 4/005

(54) **SILICON CAPACITOR ELECTRODE STRUCTURE AND SILICON CAPACITOR**

(30) Priority: 12.03.2024 CN 202410277885
(71) Applicant: Suzhou Suna Opto-Electronics Co., Ltd, Suzhou, Jiangsu 215000 (CN)
(72) Inventor: JIN, Shan, Suzhou, Jiangsu 215000 (CN); HUANG, Zhiyuan, Suzhou, Jiangsu 215000 (CN); FEI, Xiaobin, Suzhou, Jiangsu 215000 (CN); HE, Tingting, Suzhou, Jiangsu 215000 (CN); LU, Jianya, Suzhou, Jiangsu 215000 (CN); HUANG, Yuyang, Suzhou, Jiangsu 215000 (CN)
(74) Representative: Santarelli
(86) International application number: PCT/CN2025/081332
(87) International publication number: WO 2025/190175

(57) **Abstract**

The present invention relates to a silicon capacitor electrode structure and a silicon capacitor. The silicon capacitor electrode structure comprises a substrate and a columnar unit array. The substrate has a first surface. The columnar unit array is formed on the first surface of the substrate, and the columnar unit array comprises multiple columnar units arranged periodically. Each columnar unit is formed by combining multiple columns, and adjacent columns are arranged without contacting each other. Each column comprises a first main portion located in the center and two support leg portions extending in a radial direction from the first main portion, wherein the two support leg portions form an angle α₁. The silicon capacitor electrode structure and silicon capacitor of the present invention distribute columnar units on the substrate and arrange the columns within each columnar unit in a reasonable way to maximize the surface area of the electrode structure, improve structural stability, and reduce the equivalent series resistance to meet usage requirements.

## Description

The present invention claims the priority of Chinese Invention No. 2024102778853, filed with Chinese Patent Office on March 12, 2024, and entitled "Silicon Capacitor Electrode Structure And Silicon Capacitor", the entire contents of which are herein incorporated by reference.

### Technical Field

The present invention relates to the technical filed of capacitor structures, in particular to a silicon capacitor electrode structure and a silicon capacitor.

### Background of the Invention

In the field of micro-nano technology, the demand for large capacitance leads to rising costs per square inch of semiconductor substrate area and growing requirements for capacitance. To increase capacitance density, the aspect ratio of the columns, which is defined as the ratio of its length to the smallest cross-sectional dimension perpendicular to its length direction, can be increased. The strategy to increase capacitance density is to increase the length of the columns, or reduce the cross-sectional size or footprint of the columns, so that more columns can be placed on the same substrate area. However, cylindrical columns with high aspect ratios are prone to fracture and/or tilting when subjected to shear forces, such as those that may occur during handling and/or processing. Traditional electrodes typically fail to meet the requirements for electrode surface area and structural stability in specific applications, thereby limiting the employment scope of capacitors. Secondly, there exists some unreasonable arrangements of the electrodes on the substrate, resulting in high equivalent series resistance (ESR) in the electrode structures.

The information disclosed in the background art section is intended solely to provide a general background understanding of the present invention and should not be construed as acknowledging or implying in any way that such information constitutes prior art known to those skilled in the art.

### Summary of the Invention

The objective of the present invention is to provide a silicon capacitor electrode structure and a silicon capacitor, which can distribute columnar units on the substrate and arrange the columns within each columnar unit in a reasonable way, so as to maximize the surface area of the electrode structure, improve structural stability, and reduce the equivalent series resistance to meet application requirements.

To achieve the above objectives, an embodiment of the present invention provides a silicon capacitor electrode structure comprising a substrate and a columnar unit array. The substrate has a first surface. A columnar unit array is formed on the first surface of the substrate and comprises multiple columnar units distributed periodically. Each columnar unit is composed of multiple columns. The adjacent columns are not in contact with each other. Each columnar unit includes a first main portion located in the center thereof and two support leg portions extend along a radial direction from the first main portion, and an angle α₁ is formed between the two support leg portions.

In one or more embodiments of the present invention, the angle α₁ between the two support leg portions is in the range of 0°<α₁<180°, preferably 120°.

In one or more embodiments of the present invention, extension lengths of the support leg portions are same.

In one or more embodiments of the present invention, one support leg portion extends in an arc shape to the other support leg portion on a side wall surface at the angle α₁.

In one or more embodiments of the present invention, each support leg portion includes a second main portion and a connecting portion, and the connecting portion connects the second main portion and the first main portion. The first main portion is formed as a cylinder with a diameter of R₁, the second main portion is formed as a cylinder with a diameter of R₂, and the connecting portion has a length R₃ perpendicular to a line connecting a center point of the first main portion and a center point of the second main portion; and R₁ = R₂ = R₃.

In one or more embodiments of the present invention, each columnar unit comprises two identical columns, and one of the columns has a support leg portion coinciding with an angle bisector of an angle α₁ of another column.

In one or more embodiments of the present invention, the angle α₁ of the column is 120°.

In one or more embodiments of the present invention, a distance between the support leg portion coinciding with the angle bisector and the first main portion of another column is L₁₁. In a lateral direction, a lateral distance between the adjacent columnar units is L₁₂, and a longitudinal offset distance between the adjacent columnar unit is L₁₃. In a longitudinal direction, a longitudinal distance between the adjacent columnar units is L₁₄; and L₁₁, L₁₂, and L₁₄ are all greater than 0, and L₁₃ is greater than or equal to 0.

In one or more embodiments of the present invention, in a longitudinal direction, a support leg portion of one column in the columnar unit is coincident with an angle bisector of an angle α₁ of the column in another adjacent columnar unit.

In one or more embodiments of the present invention, the columnar unit comprises three identical columns, the three angles α₁ of the three columns are arranged in a ring shape outward, and the three columns form a pattern with a three-fold rotational symmetry axis.

In one or more embodiments of the present invention, each support leg portion of each column is parallel to the support leg portions of the adjacent columns.

In one or more embodiments of the present invention, the angle α₁ of the column is 120°.

In one or more embodiments of the present invention, a distance between adjacent columns is L₂₁. In a lateral direction, a lateral distance between the adjacent columnar units is L₂₂. A longitudinal offset distance between the adjacent columnar units is L₂₃. In a longitudinal direction, a longitudinal distance between the adjacent columnar units is L₂₄; and L₂₁, L₂₂, L₂₃, and L₂₄ are all greater than 0.

In one or more embodiments of the present invention, a structure of one column in the columnar units in which the angle of the column is directed downward, is defined as a forward-facing columnar unit, and the columnar unit array is entirely composed of the forward-facing columnar units.

In one or more embodiments of the present invention, the support leg portions of one column in one columnar unit are correspond to sides of one column in the adjacent columnar unit.

In one or more embodiments of the present invention, a structure of one column in the columnar units, in which the angle of the column is directed downward, is defined as a forward-facing columnar unit; a structure of one column in the columnar units, in which the angle of the column is directed upward, is defined as a reverse-facing columnar unit; the columnar unit array is composed of the forward-facing columnar units and the reverse-facing columnar units arranged in combination.

In one or more embodiments of the present invention, each columnar unit comprises four identical columns, the four angles α₁ of the four columns are arranged in a ring shape outward, and the four columns form a pattern with a four-fold rotational symmetry axis.

In one or more embodiments of the present invention, each support leg portion of each column is parallel to the support leg portions of the adjacent columns.

In one or more embodiments of the present invention, the angle α₁ of the column is 90°.

In one or more embodiments of the present invention, a distance between adjacent columns is L₃₁. In a lateral direction, a lateral distance between the adjacent columnar units is L₃₂. A longitudinal offset distance between the adjacent columnar units is L₃₃. In a longitudinal direction, a longitudinal distance between the adjacent columnar units is L₃₄; and L₃₁, L₃₂, L₃₃, and L₃₄ are all greater than 0.

The present invention also provides a silicon capacitor comprising the silicon capacitor electrode structure described above.

Compared with the prior art, the silicon capacitor electrode structure according to the embodiment of the present invention distributes the columnar units on the substrate and arranges the columns within each columnar unit in a reasonable way, which can increase the surface area of the electrode in a limited space, improve the capacitance of the capacitor, and enable it to store more charge. Moreover, while maximizing the surface area of the electrode structure, the structural stability is improved and the equivalent series resistance is reduced to meet application requirements.

The silicon capacitor electrode structure according to the embodiment of the present invention reduces the accumulation of electrons on the outer peripheral surface through the special shape of the columns. Meanwhile, the special arrangement of the columns and columnar units further reduces the equivalent series resistance (ESR) of the silicon capacitor electrode structure.

The silicon capacitor electrode structure according to the embodiment of the present invention increases the surface area by arranging columns and columnar units composed of columns, thereby reducing the volume of the capacitor while maintaining the capacitance unchanged, which is very important for integration into small electronic devices, enabling higher capacitance in a limited space.

The silicon capacitor electrode structure according to the embodiment of the present invention can improve energy density. Since the energy density of a capacitor is related to its capacitance and operating voltage, the increment of the capacitance allows more energy to be stored in the same volume. The silicon capacitor electrode structure of the present embodiment increases the surface area of the electrodes in the same space and improves the capacitance of the capacitor by arranging columns and columnar units composed of columns.

The silicon capacitor electrode structure according to the embodiment of the present invention can further improve performance and stability. The periodically distributed columnar units can provide a uniform electric field distribution, which helps to improve the performance and stability of the capacitor. A uniform electric field distribution helps reduce the leakage current of the capacitor, improve insulation performance, and lower losses. The periodically distributed columnar units can be achieved through precise manufacturing processes, enhancing the consistency of the manufacturing process. This also helps reduce performance variations between capacitors and improve manufacturing controllability.

The silicon capacitor electrode structure according to the invention improves mechanical stability and enhances heat dissipation performance. The periodic distribution of the columnar units provides better mechanical stability. This is particularly important for capacitors used in environments subject to vibration or mechanical stress. The periodic distribution of the columnar units improves the heat dissipation performance of the capacitor, as the gaps between the units facilitate air flow and reduce the operating temperature of the capacitor.

According to the silicon capacitor electrode structure of the embodiment of the present invention, multiple columnar units are periodically arranged through a random path identical dielectric (resistance) model, which makes it easier to obtain information about the distribution of conductive paths and charge transfer behavior in the silicon capacitor electrode structure.

According to the silicon capacitor electrode structure of the embodiment of the present invention, by simulating and analyzing the periodic arrangement of multiple columnar units using a random conductive path percolation model, and simulating the equivalent random parallel resistance of the capacitor three-dimensional (3D) structure, a better design of the 3D morphology and prediction of the capacitor ESR can be obtained.

### Brief Description of the Drawings

FIG. 1 is a schematic diagram of the planar morphology of the silicon capacitor electrode structure according to a first embodiment of the present invention.
FIG. 2 is an enlarged view showing part of FIG. 1.
FIGS. 3 and 4 are schematic diagrams of the planar morphology of the silicon capacitor electrode structures with different distances according to a first embodiment of the present invention.
FIG. 5a illustrates a capacitance density simulation diagram of the silicon capacitor electrode structure according to the first embodiment of the present invention and the electrode structure of the traditional trident column model.
FIG. 5b is a normalized ESR simulation diagram of the silicon capacitor electrode structure according to the first embodiment of the present invention and the electrode structure of the traditional trident column model.
FIG. 6 is a schematic diagram of the planar morphology of the silicon capacitor electrode structure according to a second embodiment of the present invention.
FIG. 7 is an enlarged view showing part of FIG. 6.
FIG. 8a is a simulation of the capacitance of two adjacent columns with different L₂₁ in the columnar unit of the silicon capacitor electrode structure according to the second embodiment of the present invention.
FIG. 8b is a simulation of the impedance of two adjacent columns with different L₂₁ in the columnar unit of the silicon capacitor electrode structure according to the second embodiment of the present invention.
FIGS. 9-11 are schematic diagrams of the planar morphology of a silicon capacitor electrode structure with another distance according to the second embodiment of the present invention.
FIG. 12a is a capacitance density diagram of the silicon capacitor electrode structure with different L₂₄ values between adjacent columnar units according to the second embodiment of the present invention.
FIG. 12b is a simulation of the capacitance density of the silicon capacitor electrode structure with different L₂₄ values between adjacent columnar units according to the second embodiment of the present invention.
FIG. 13a is a simulation diagram of the capacitance density of the silicon capacitor electrode structure according to the second embodiment of the present invention and the electrode structure of the traditional trident column model.
FIG. 13b is a normalized ESR simulation diagram of the silicon capacitor electrode structure according to the second embodiment of the present invention and the electrode structure of the traditional trident column model.
FIGS. 14-16 are schematic diagrams of the planar morphology of a silicon capacitor electrode structure with different distance according to the third embodiment of the present invention.
FIG. 17a is a capacitance density diagram of the silicon capacitor electrode structure with different L₂₄ values between adjacent columnar units according to the third embodiment of the present invention.
FIG. 17b is a simulation of the capacitance density of the silicon capacitor electrode structure with different L₂₄ values between adjacent columnar units according to the third embodiment of the present invention.
FIG. 18a is a capacitance density diagram of the silicon capacitor electrode structure with different L₂₂ values between adjacent columnar units according to the third embodiment of the present invention.
FIG. 18b is a simulation of the capacitance density of the silicon capacitor electrode structure with different L₂₂ values between adjacent columnar units according to the third embodiment of the present invention.
FIG. 19a is a simulation diagram of the capacitance density of the silicon capacitor electrode structure according to the third embodiment of the present invention and the electrode structure of the traditional trident column model.
FIG. 19b is a normalized ESR simulation diagram of the silicon capacitor electrode structure according to the third embodiment of the present invention and the electrode structure of the traditional trident column model.
FIG. 20 is a schematic diagram of the planar morphology of the silicon capacitor electrode structure according to a fourth embodiment of the present invention.
FIG. 21 is an enlarged view showing part of FIG. 20.
FIG. 22a is a simulation of the capacitance of two adjacent columns with different L₃₁ in the columnar unit of the silicon capacitor electrode structure according to the fourth embodiment of the present invention.
FIG. 22b is a simulation of the impedance of two adjacent columns with different L₃₁ in the columnar unit of the silicon capacitor electrode structure according to the fourth embodiment of the present invention.
FIGS. 23-25 are schematic diagrams of the planar morphology of a silicon capacitor electrode structure with different distance according to the fourth embodiment of the present invention.
FIG. 26a is a capacitance density diagram of the silicon capacitor electrode structure with different L₃₄ values between adjacent columnar units according to the fourth embodiment of the present invention.
FIG. 26b is a simulation of the capacitance density of the silicon capacitor electrode structure with different L₃₄ values between adjacent columnar units according to the fourth embodiment of the present invention.
FIG. 27a is a capacitance density diagram of the silicon capacitor electrode structure with different L₃₂ values between adjacent columnar units according to the fourth embodiment of the present invention.
FIG. 27b is a simulation of the capacitance density of the silicon capacitor electrode structure with different L₃₂ values between adjacent columnar units according to the fourth embodiment of the present invention.
FIG. 28a is a simulation diagram of the capacitance density of the silicon capacitor electrode structure according to the fourth embodiment of the present invention and the electrode structure of the traditional trident column model.
FIG. 29b is a normalized ESR simulation diagram of the silicon capacitor electrode structure according to the fourth embodiment of the present invention and the electrode structure of the traditional trident column model.
FIG. 30 is a schematic diagram of the planar morphology of the electrode structure of the traditional trident column model.

### Detailed Description of Embodiments

The following description of the specific embodiments of the present invention is provided with reference to the accompanying drawings. However, it should be understood that the scope of protection of the present invention is not limited to the specific embodiments described herein.

Unless otherwise explicitly stated, the term "include" or its variations such as 'comprising' or "including" and the like shall be understood to include the elements or components described herein, without excluding other elements or components.

As disclosed in the section of background art, in order to increase the capacitance density, the ratio of the length to the width of the column can be increased, i.e., the length of the column can be increased or the cross-sectional size or footprint of the column can be reduced, so that more columns can be placed on the same substrate area. However, cylindrical columns with high aspect ratios are prone to fracture and/or tilting when subjected to shear forces, such as those that may occur during handling and/or processing. Traditional electrodes typically fail to meet the requirements for electrode surface area and structural stability in specific applications, thereby limiting the employment scope of capacitors. Secondly, there exists some unreasonable arrangements of the electrodes on the substrate, resulting in high equivalent series resistance (ESR) in the electrode structures.

To address the aforementioned problems, the present invention provides a silicon capacitor electrode structure based on a Random Path Identical Dielectric (Resistance) Model and a Random Conductive Path Percolation Model. First, the stability of the electrode structure is enhanced by constructing a column with a main portion and two support leg portions. Meanwhile, the columns are arranged in a reasonable way to form columnar units, and the columnar units are periodically distributed on the substrate to enhance the stress-bearing capacity of the columnar units while further increasing the surface area of the electrodes in a limited space and reducing the equivalent series resistance to meet usage requirements.

The Random Path Identical Dielectric (Resistance) Model is used to describe the distribution and properties of randomly distributed conductive paths in dielectric materials. This model is applied to analyze the electrical conductivity behavior in complex dielectric, where charges are transported through randomly distributed conductive paths within the material. By simulating and analyzing the Random Path Identical Dielectric Model, information about the distribution of conductive paths and charge transport behavior within the material can be obtained. This model is a theoretical simplification, and the actual electrical behavior of materials may be influenced by additional factors such as material microstructure and the properties of charge carriers. When the Random Path Identical Dielectric (Resistance) Model used, appropriate modifications and verification should be performed based on the specific material and experimental conditions to ensure the accuracy and applicability of the model.

The Random Conductive Path Percolation Model may be employed to describe the distribution and properties of randomly distributed conductive paths in complex dielectric materials. This model may be applied to analyze the percolation behavior of conductivity in materials. The Random Conductive Path Percolation Model may be utilized to characterize the random parallel properties of 3D capacitive equivalent resistance, taking into account the random distribution of conductive paths. The equivalent resistances are connected in parallel in a periodic and regular distribution. By simulating and analyzing such random parallel configurations, the Random Conductive Path Percolation Model may facilitate improved prediction of equivalent series resistance (ESR).

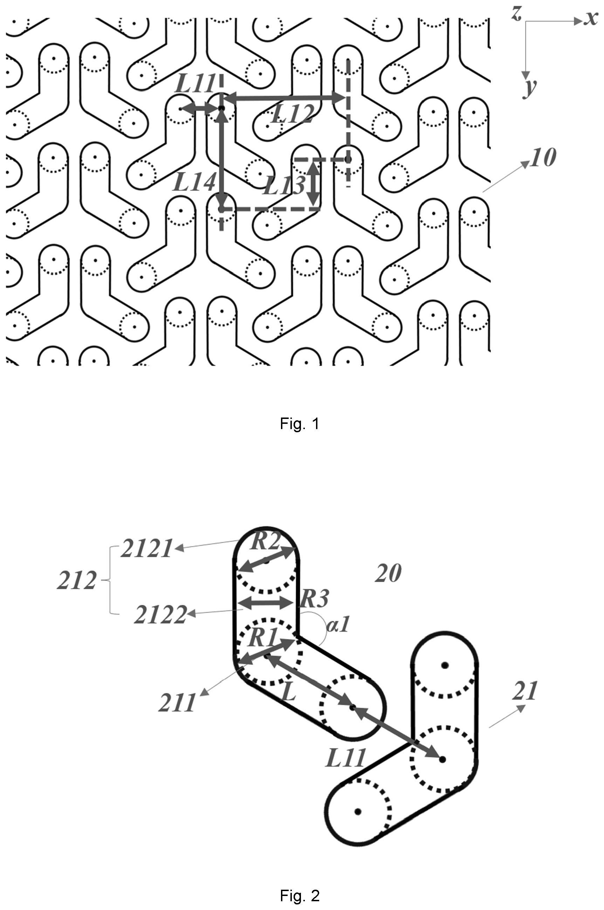

As shown in FIGS. 1, 6, 14, and 20, a silicon capacitor electrode structure of the present invention comprises a substrate 10, a columnar unit array formed on the substrate 10.

The substrate 10 has a first surface that serves as a bottom support for the columnar unit array. A three-dimensional Cartesian coordinate system is established with the first surface of substrate 10 as the bottom plane. A lateral direction is defined as an x-direction, a longitudinal direction is defined as a y-direction, and a direction perpendicular to the first surface is defined as a z-direction.

A columnar unit array is formed on the first surface of the substrate 10. The columnar unit array includes a plurality of columnar units 20 distributed periodically. Each columnar unit 20 is composed of a plurality of columns 21 arranged in combination. The adjacent columns 21 are arranged so as not to contact each other.

As shown in FIG. 2, the column 21 extends in the z-direction from the first surface and has an extended length L_{Z1}. The column 21 is a part of the electrode structure. Each column 21 includes a first main portion 211 located in the center thereof and two support leg portions 212 extending in a radial direction from the first main portion 211, wherein the two support leg portions 212 have the same length and the two support leg portions 212 form an angle α₁ therebetween. The angle α₁ is in the range of 0°<α1<180°. For easier manufacturing, one support leg portion 212 extends to the other support leg portion 212 in an arc shape on the side wall surface at the angle α₁, and the angle α₁ ranges from 90° to 180°, with 120° being optimal. In the z-direction, the first main portion 211 and the two support leg portions 212 are of the same length, being L_{Z1}. Each support leg portion 212 includes a second main portion 2121 and a connecting portion 2122, the latter connecting the second main portion 2121 and the first main portion 211. Preferably, the first main portion 211 is constructed as a circular columnar structure with a diameter of R₁. The second main portion 2121 is constructed as a circular column structure with a diameter of R₂. The connecting line connecting a center point of the first main portion 211 and a center point of each second main portion 2121 of the column 21 has the same length L, and the length L is greater than or equal to a half of the circumference of the first main portion 211 or the second main portion 2121. This configuration makes the column 21 have a larger surface area. The connecting portion 2122 has a length R₃ perpendicular to a line connecting the center point of the first main portion 211 and the center point of the second main portion 2121, and R₁ = R₂ = R₃. Therefore, the first main portion 211 has a first cross section perpendicular to the first surface (i.e., in the z-direction) and passing through the center point of the first main portion 211. The second main portion 2121 has a second cross section perpendicular to the first surface (i.e., in the z-direction) and passing through the center point of the second main portion 2121. The connecting portion 2122 has a third cross section perpendicular to a line connecting the center point of the first main portion 211 and the center point of the second main portion 2121 and perpendicular to the first surface. The connecting portion 2122 always completely coincides with the first cross section of the first main portion 211 and the second cross section of the second main portion 2121 in any of the third cross sections in the direction from the first main portion 211 to the second main portion 2121.

Referring to FIG. 1, in a first embodiment of the present invention, a plurality of columnar units 20 are arranged in the lateral direction (x-direction) at equal intervals L₁₂ and in the longitudinal direction (y-direction) at equal intervals L₁₄. Meanwhile, in the lateral direction (x-direction), adjacent columnar units 20 have a longitudinal offset distance L₁₃, where the values of L₁₂ and L₁₄ are greater than 0, and the value of L₁₃ can be greater than 0 or equal to 0. It can be understood that L₁₂ is defined as a lateral distance between the center points of the first main portions of the corresponding two columns in laterally adjacent columnar units. L₁₄ is defined as a longitudinal distance between the center points of the first main portions of the corresponding two columns in longitudinally adjacent columnar units. L₁₃ is defined as a longitudinal offset distance between the center points of the first main portions of the corresponding two columns in laterally adjacent columnar units.

Referring to FIG. 2, in the first embodiment of the present invention, each columnar unit 20 includes two identical columns 21. **In** this embodiment, the angle α₁ between each column 21 is 120°. The two columns 21 are arranged such that one support leg portion 212 of one column extends in the longitudinal direction (y-direction) and the other support leg portion 212 coincides with an angle bisector of the angle α₁ of another column. A distance between the support leg portion 212 coinciding with the angle bisector and the first main portion 211 of the other column 21 is L₁₁. It is understood that L₁₁ is defined as a straight-line distance between the center point of the second main portion 2121 of the support leg portion 212 and the center point of the first main portion 211 of another column 21. L₁₁ is smaller than L₁₂, and L₁₁ is smaller than L₁₄.

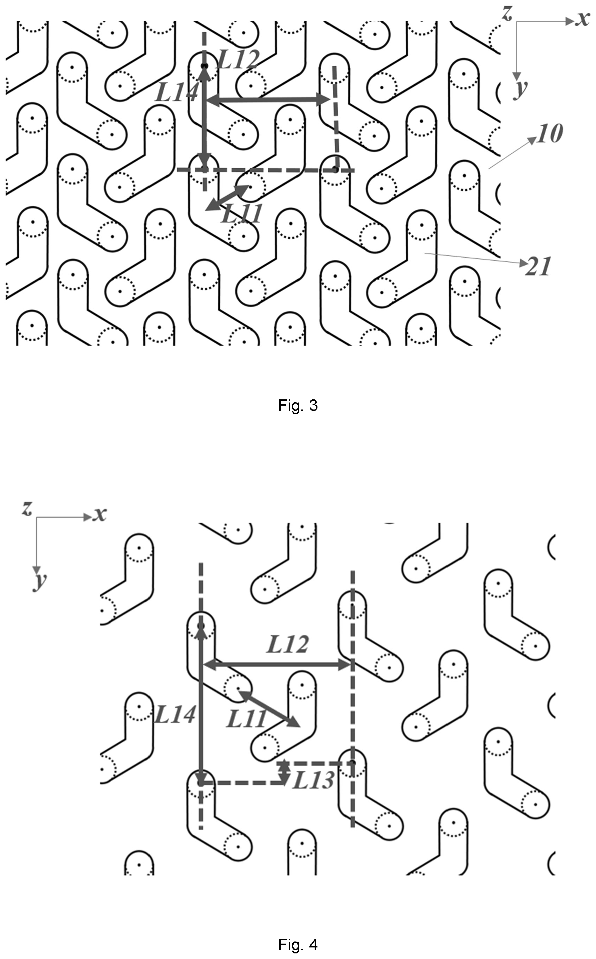

Referring to FIGS. 1, 3, and 4, the arrangement density of the columnar units 20 in the silicon capacitor electrode structure is different depending on the different values of L₁₁, L₁₂, L₁₃, and L₁₄. When the values of L₁₁, L₁₂, L₁₃, and L₁₄ are small, the silicon capacitor electrode structure shown in FIG. 1 is formed, and the columnar units 20 are distributed relatively densely on the substrate 10. On this basis, when the value of L₁₃ is 0, the silicon capacitor electrode structure shown in FIG. 3 is formed. When the values of L₁₁, L₁₂, L₁₃, and L₁₄ are large, a silicon capacitor electrode structure as shown in FIG. 4 is formed, and the columnar units 20 on the substrate 10 are distributed relatively sparsely.

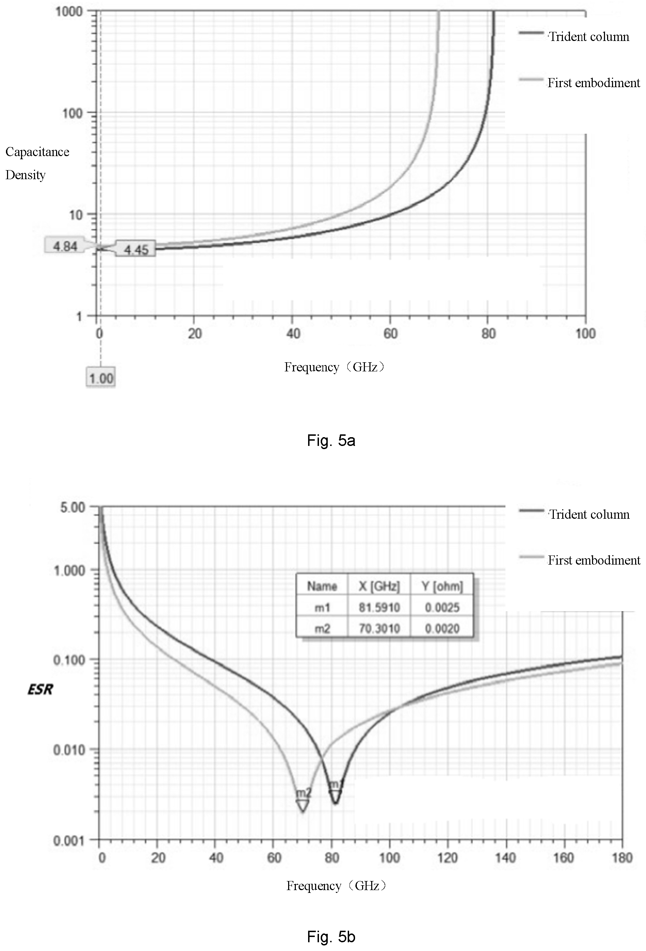

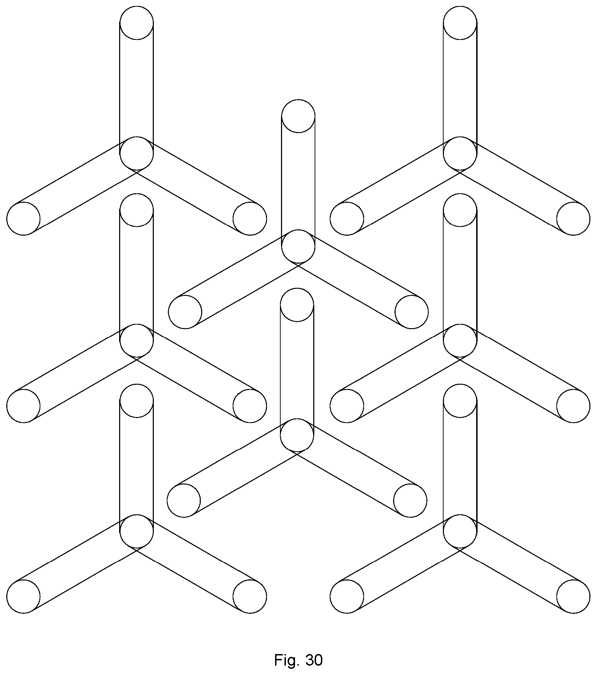

FIG. 5a is a capacitance density simulation diagram of the silicon capacitor electrode structure in the first embodiment shown in FIG. 1 or FIG. 3 of the present invention and the electrode structure of the arrayed trident column model in the prior art shown in FIG. 30. It can be seen from the figure that C _{first embodiment} = 4.84 nF/mm²@1 GHz, C _{trident column} = 4.45 nF/mm²@1 GHz.

FIG. 5b is a normalized ESR simulation diagram of the silicon capacitor electrode structure in the first embodiment shown in FIG. 1 or FIG. 3 of the present invention and the electrode structure of the arrayed trident column model in the prior art shown in FIG. 30. It can be seen from the figure that ESR _{first embodiment} = 2.0 mOhm@SRF, ESR _{trident column} = 2.5 mOhm@SRF.

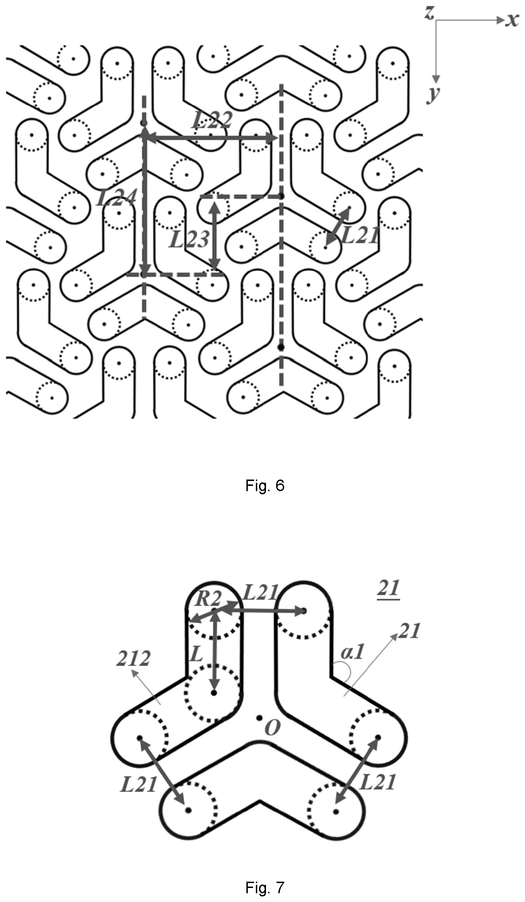

Referring to FIG. 6, in a second embodiment of the present invention, a plurality of columnar units 20 are arranged in the lateral direction (x-direction) at equal intervals L₂₂ and in the longitudinal direction (y-direction) at equal intervals L₂₄. Meanwhile, in the lateral direction (x-direction), adjacent columnar units 20 have a longitudinal offset distance L₂₃, where the values of L₂₂ and L₂₄ are greater than 0, and the value of L₂₃ can be greater than 0 or equal to 0. **It** can be understood that L₂₂ is defined as a lateral distance between the center points of laterally adjacent columnar units. L₂₄ is defined as a longitudinal distance between the center points of longitudinally adjacent columnar units. L₂₃ is defined as an offset distance in the longitudinal direction between the center points of adjacent columnar units in the lateral direction.

Referring to FIG. 7, in a second embodiment of the present invention, each columnar unit 20 includes three identical columns 21. In this embodiment, the angle α₁ of each column 21 can be greater than 0° and less than 180°, but preferably the angle α₁ is 120°. The arrangement of the three columns 21 is as follows: the three angles of the three columns are set outward, and the three columns are arranged in a ring shape. The three columns form a pattern with a three-fold rotational symmetry axis, and the center point of the axis is O. It can be understood that when a pattern rotates once around an axis and returns to its original position, this axis is referred to a rotational symmetry axis; if it can return to its original position n times during one full rotation, the axis is referred to as an n-fold rotational symmetry axis. Accordingly, the three-fold rotational symmetry axis means that the columnar unit 20 in this embodiment can return to its original position three times during one full rotation about point O. In this embodiment, the support leg portions 212 of each column 21 are parallel to the support leg portions 212 of the other columns 21 adjacent thereto, and the distance between the adjacent support leg portions 212 of two adjacent columns 21 is defined as L₂₁. It can be understood that L₂₁ is defined as a straight-line distance between the center points of the second main portion 212 of the support leg portions 212 of two adjacent columns 21. L₂₁ is smaller than L₂₂, and L₂₁ is smaller than L₂₄.

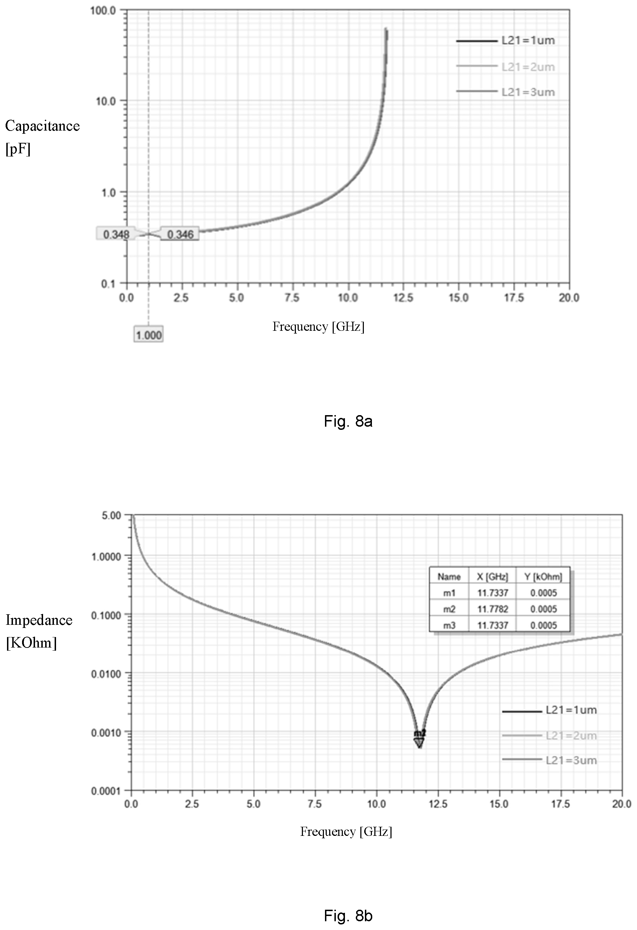

Referring to FIGS. 8a and 8b, the values of L₂₁ are selected as 1 µm, 2 µm, and 3 µm, respectively, and other variables remain unchanged. By simulating the capacitance and impedance of the silicon capacitor formed by the silicon capacitor electrode structure composed of columnar units with different values of L₂₁, it is found that the change in the value of L₂₁ has little effect on the capacitance density and impedance.

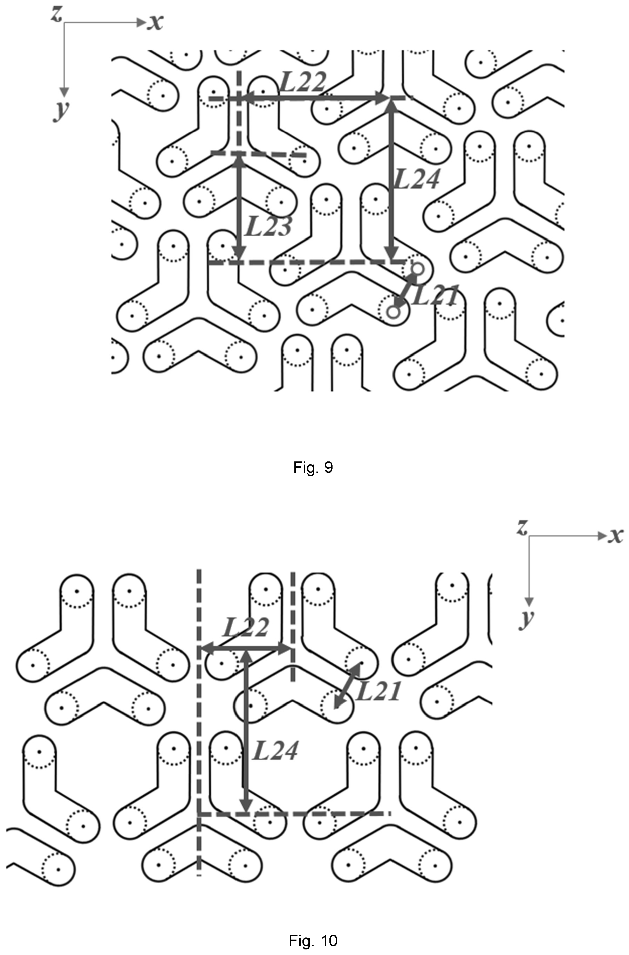

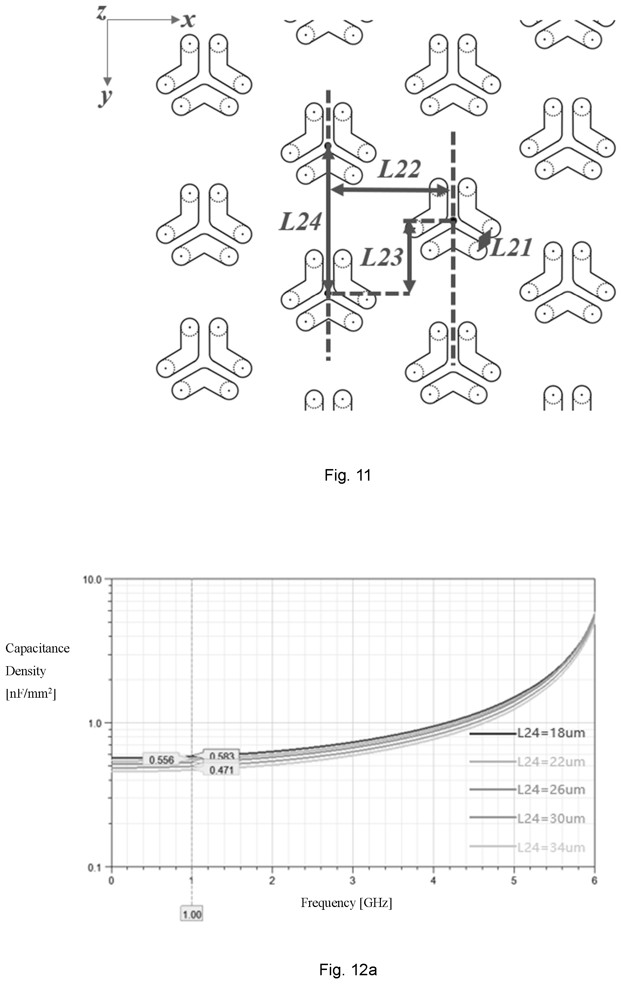

Referring to FIGS. 6, 9 to 11, in the above figures, the columnar units 20 are all forward-facing columnar units, that is, one of the columns 21 in the columnar unit 20 has an angle in the longitudinal direction (y-direction) that is set forward downward, and the columnar unit 20 positioning this state is a forward-facing columnar unit. In the second embodiment of the present invention, the columnar unit array is entirely composed of forward-facing columnar units 20. Furthermore, referring to FIGS. 6, 9 to 11, depending on the different values of L₂₁, L₂₂, L₂₃, and L₂₄, the arrangement density of the columnar units 20 in the silicon capacitor electrode structure is different. When the values of L₂₁, L₂₂, L₂₃, and L₂₄ are small, the silicon capacitor electrode structure shown in FIG. 6 is formed, and the columnar units 20 on the substrate 10 are distributed relatively densely. In the silicon capacitor electrode structure shown in FIG. 6, the support leg portions 212 of each pair of adjacent columns 21 within one columnar unit 20 are correspond to the sides of one column 21 within the other columnar unit 20 adjacent to the one columnar unit 20. As the values of L₂₁, L₂₂, L₂₃, and L₂₄ increase, a silicon capacitor electrode structure shown in FIG. 9 is formed, and the distribution of columnar units 20 on the substrate 10 becomes relatively sparse. On this basis, when the value of L₂₃ is 0, a silicon capacitor electrode structure as shown in FIG. 10 is formed, and the distribution of columnar units 20 on the substrate 10 is already quite sparse to ensure the columnar units 20 not in contact with each other. When the values of L₂₁, L₂₂, L₂₃, and L₂₄ are large, a silicon capacitor electrode structure as shown in FIG. 11 is formed, and the distribution of columnar units 20 on the substrate 10 is very sparse.

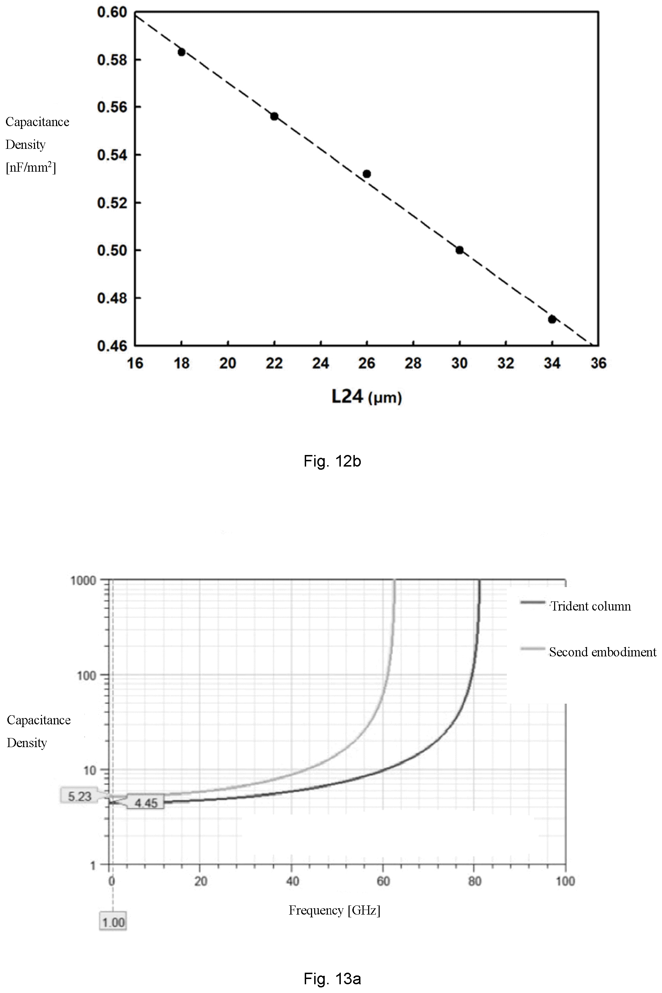

Referring to FIGS. 12a and 12b, the values of L₂₄ are selected as 18 µm, 22 µm, 26 µm, 30 µm, and 34 µm, respectively, and other variables remain unchanged. The capacitance of the silicon capacitor formed by the silicon capacitor electrode structure composed of columnar units with different L₂₄ was simulated, and the capacitance density under different L₂₄ was calculated, and the result is that C _{densityL24=18um} = 0.583nF/mm²; C_{densityL24=22um} = 0.556nF/mm²; C _{densityL24 = 26 µm} = 0.532 nF/mm²; C _{densityL24 = 30 µm} = 0.500 nF/mm²; C _{densityL24 = 34 µm} = 0.471 nF/mm². Therefore, it can be concluded that the smaller the value of L₂₄, the higher the capacitance density.

FIG. 13a shows a capacitance density simulation diagram of the silicon capacitor electrode structure in the second embodiment shown in FIG. 6 of the present invention and the electrode structure of the arrayed trident column model in the prior art shown in FIG. 30. It can be seen from the figure that C _{second embodiment} = 5.23 nF/mm²@1 GHz, C trident column= 4.45 nF/mm² @ 1 GHz.

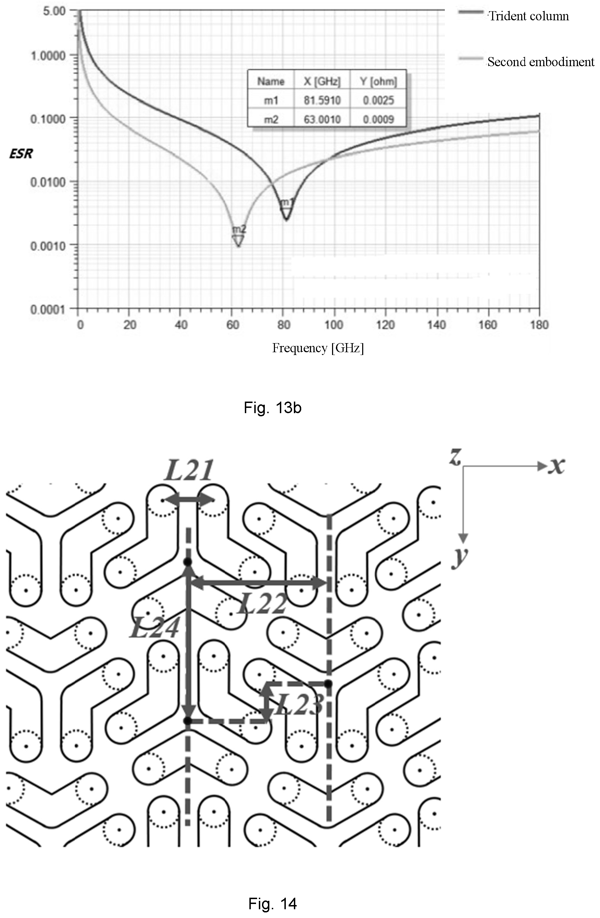

FIG. 13b is a normalized ESR simulation diagram of the silicon capacitor electrode structure in the second embodiment shown in FIG. 6 of the present invention and the electrode structure of the arrayed trident column model in the prior art shown in FIG. 30. It can be seen from the figure that ESR _{second embodiment} = 0.9 mOhm@SRF, ESR _{trident column} = 2.5 mOhm@SRF.

Referring to FIGS. 14 to 16, in a third embodiment of the present invention, the structure of the columnar unit 20 is the same as that in the second embodiment of the present invention. The difference is that the columnar unit 20 is arranged differently on the substrate 10. In the second embodiment of the present invention, it is defined that a columnar unit 20 in which one of the columns 21 is set downward in the longitudinal direction (y-direction) is a forward-facing columnar unit, and a columnar unit 20 in which one of the columns 21 is set upward in the longitudinal direction (y-direction) is defined as a reverse-facing columnar unit. Therefore, in the third embodiment of the present invention, the columnar unit array is arranged by alternating a column of forward-facing columnar units and a column of reverse-facing columnar units.

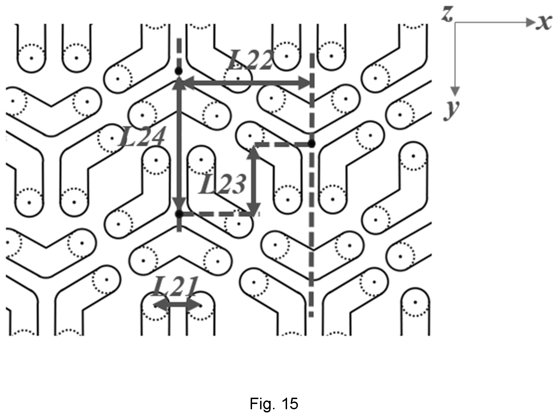

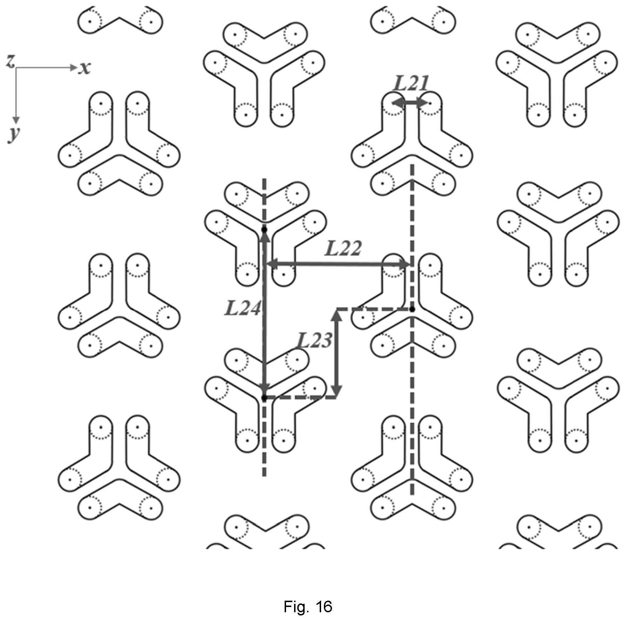

Referring to FIGS. 14 to 16, the distribution density of the columnar units 20 in the silicon capacitor electrode structure differs depending on the different values of L₂₁, L₂₂, L₂₃, and L₂₄. When the values of L₂₁, L₂₂, L₂₃, and L₂₄ are small, the silicon capacitor electrode structure shown in FIG. 14 is formed, and the columnar units 20 are distributed relatively densely on the substrate 10. As the values of L₂₁, L₂₂, L₂₃, and L₂₄ increase, the silicon capacitor electrode structure shown in FIG. 15 is formed, and the distribution of columnar units 20 on the substrate 10 becomes relatively sparse. When the values of L₂₁, L₂₂, L₂₃, and L₂₄ are large, a silicon capacitor electrode structure as shown in FIG. 16 is formed, and the distribution of columnar units 20 on the substrate 10 is very sparse.

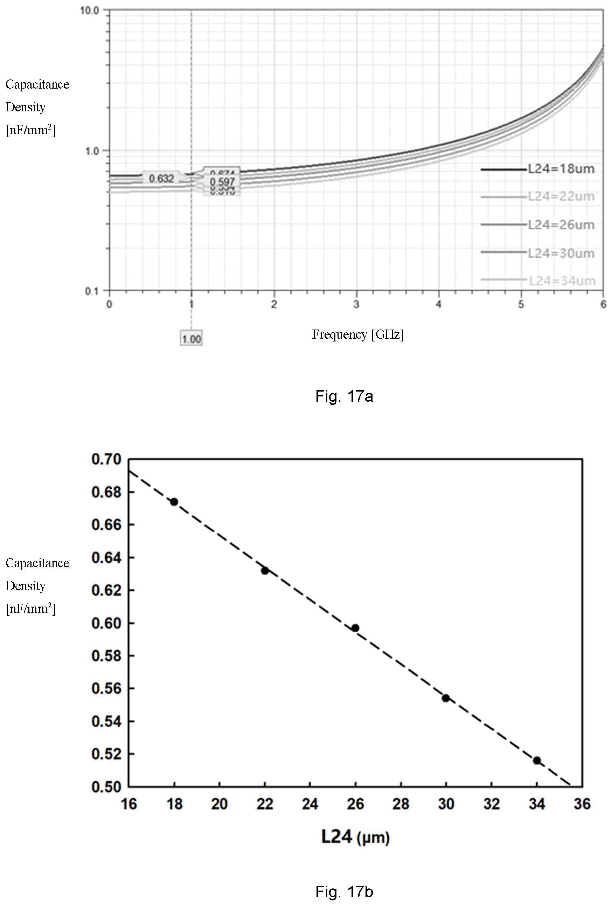

Referring to FIGS. 17a and 17b, the values of L₂₄ are selected as 18 µm, 22 µm, 26 µm, 30 µm, and 34 µm, respectively, and other variables remain unchanged. The capacitance of the silicon capacitor formed by the silicon capacitor electrode structure composed of columnar units with different L₂₄ is simulated, and the capacitance density under different L₂₄ is calculated, and the result is that C _{densityL24=18um} = 0.674nF/mm²; C _{densityL24 = 22 µm} = 0.632 nF/mm²; C _{densityL24 = 26 µm} = 0.597 nF/mm²; C _{densityL24 = 30 µm} = 0.554 nF/mm²; C _{densityL24 = 34 µm} = 0.516 nF/mm².

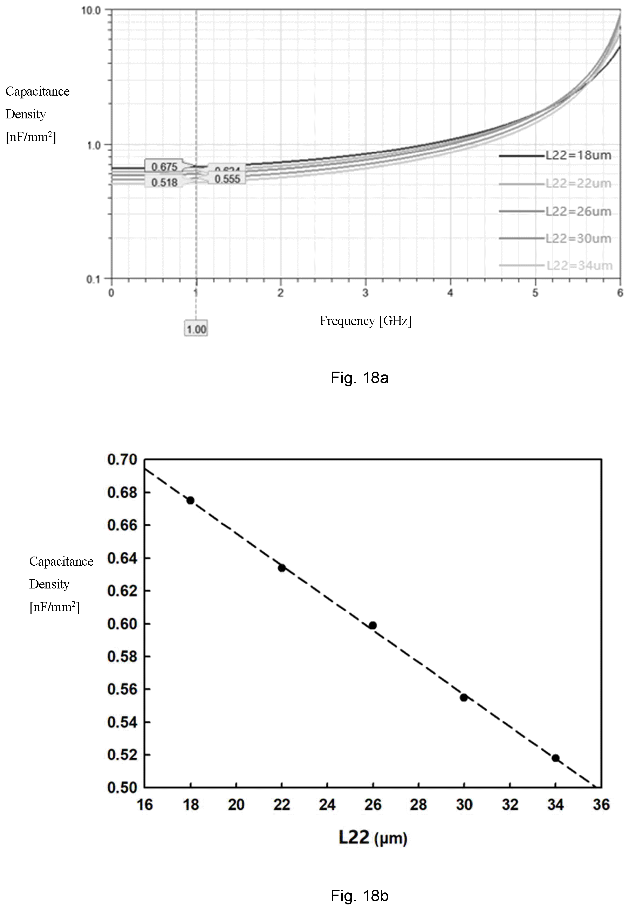

Referring to FIGS. 18a and 18b, the values of L₂₂ are selected as 18 µm, 22 µm, 26 µm, 30 µm, and 34 µm, respectively, and other variables remain unchanged. The capacitance of the silicon capacitor formed by the silicon capacitor electrode structure composed of columnar units with different L₂₂ was simulated, and the capacitance density under different L₂₂ was calculated, resulting in C _{densityL22=18um} = 0.675nF/mm²; C _{densityL22} = _{22 µm} = 0.634 nF/mm²; C _{densityL22} = _{26 µm} = 0.599 nF/mm²; C _{densityL22 = 30 µm} = 0.555 nF/mm²; C _{densityL22 = 34 µm} = 0.518 nF/mm².

Therefore, it can be concluded that a decrease in the values of L₂₄ and L₂₂ results in an increase in capacitance density.

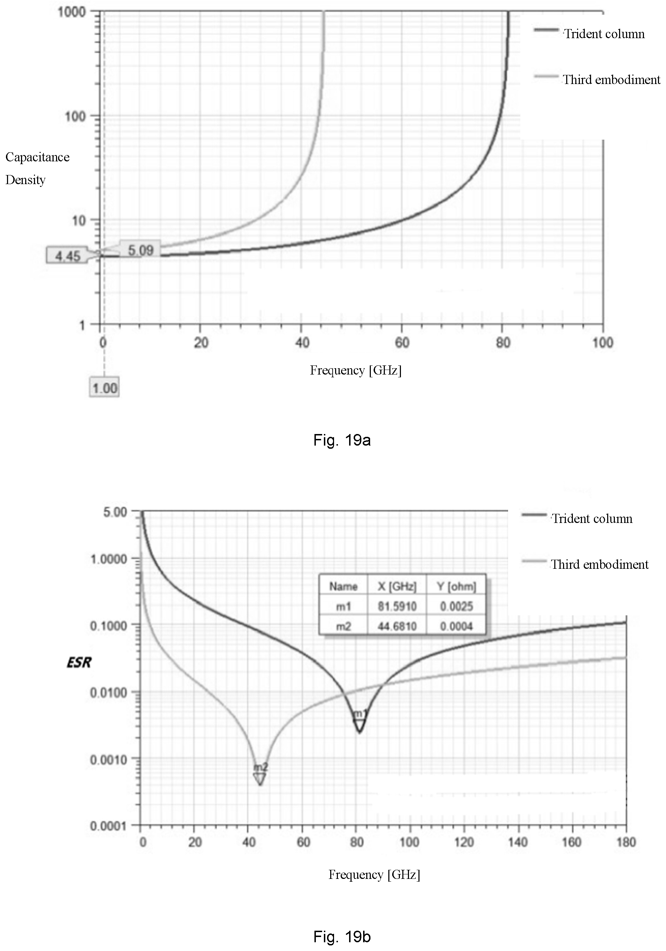

FIG. 19a is a capacitance density simulation diagram of the silicon capacitor electrode structure in the third embodiment shown in FIG. 14 of the present invention and the electrode structure of the arrayed trident column model in the prior art shown in FIG. 30. It can be seen from the figure that C third embodiment = 5.09 nF/mm²@1 GHz, C trident column = 4.45 nF/mm²@1 GHz.

FIG. 19b is a normalized ESR simulation diagram of the silicon capacitor electrode structure in the third embodiment shown in FIG. 14 of the present invention and the electrode structure of the arrayed trident column model in the prior art shown in FIG. 30. It can be seen from the figure that ESR_{third embodiment} = 0.4mohm@SRF, ESR_{trident column} = 2.5mohm@SRF.

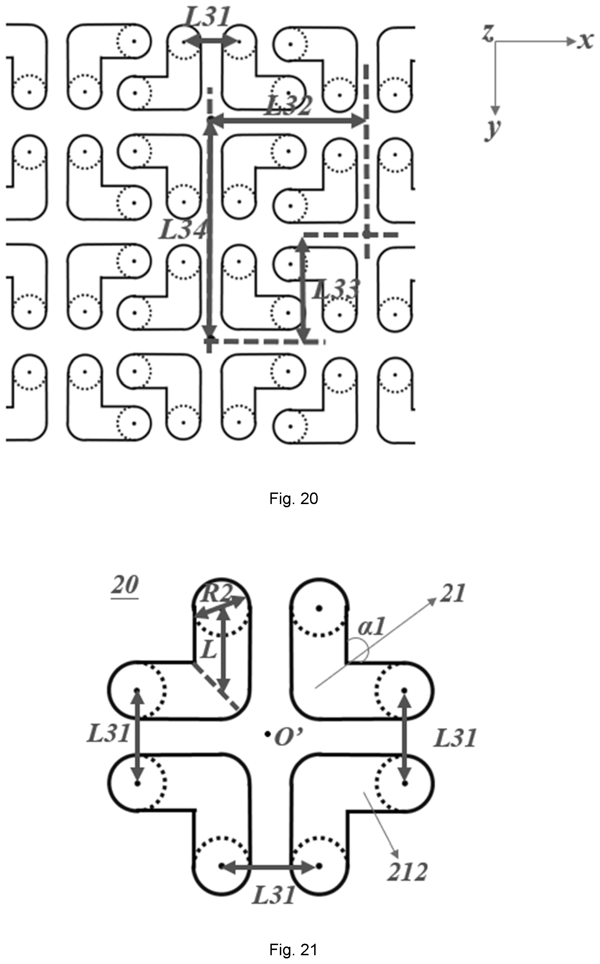

Referring to FIG. 20, in a fourth embodiment of the present invention, a plurality of columnar units 20 are arranged in the lateral direction (x-direction) at equal intervals L₃₂ and in the longitudinal direction (y-direction) at equal intervals L₃₄. Meanwhile, in the lateral direction (x-direction), adjacent columnar units 20 have a longitudinal offset distance L₃₃, where the values of L₃₂ and L₃₄ are greater than 0, and the value of L₃₃ can be greater than 0 or equal to 0. It can be understood that L₃₂ is defined as a lateral distance between the center points of adjacent columnar units in the lateral direction. L₃₄ is defined as the longitudinal distance between the center points of adjacent columnar units in the longitudinal direction. L₃₃ is defined as a longitudinal offset distance between the center points of adjacent columnar units in the lateral direction.

Referring to FIG. 21, in a fourth embodiment of the present invention, each columnar unit 20 includes four identical columns 21. In this embodiment, the angle α₁ of each column 21 can be greater than 0° and less than 180°, but preferably the angle α₁ is 90°. The four columns 21 are arranged as follows: the four angles of the four columns are all set outward, and the four columns are arranged in a ring shape, with the four columns forming a pattern with a four-fold rotational symmetry axis, and the center point of the axis is O'. It can be understood that when a pattern can be completely restored after rotating one revolution around a certain axis, this axis is called a rotational symmetry axis, and when it can be restored n times during one revolution, it is called an n-fold rotational symmetry axis. Therefore, the pattern with a four-fold rotational symmetry axis means that the columnar unit 20 in this embodiment can return to its original position four times during one revolution around point O'. In this embodiment, the support leg portions 212 of each column 21 are parallel to the support leg portions 212 of other column 21 adjacent to the column 21, and the distance between the adjacent support leg portions 212 of two adjacent columns 21 is L₃₁. It can be understood that L₃₁ is defined as the straight-line distance between the center points of the second main portion 2121 of the support leg portions 212 of two adjacent columns 21, and L₃₁ is smaller than L₃₂, and L₃₁ is smaller than L₃₄.

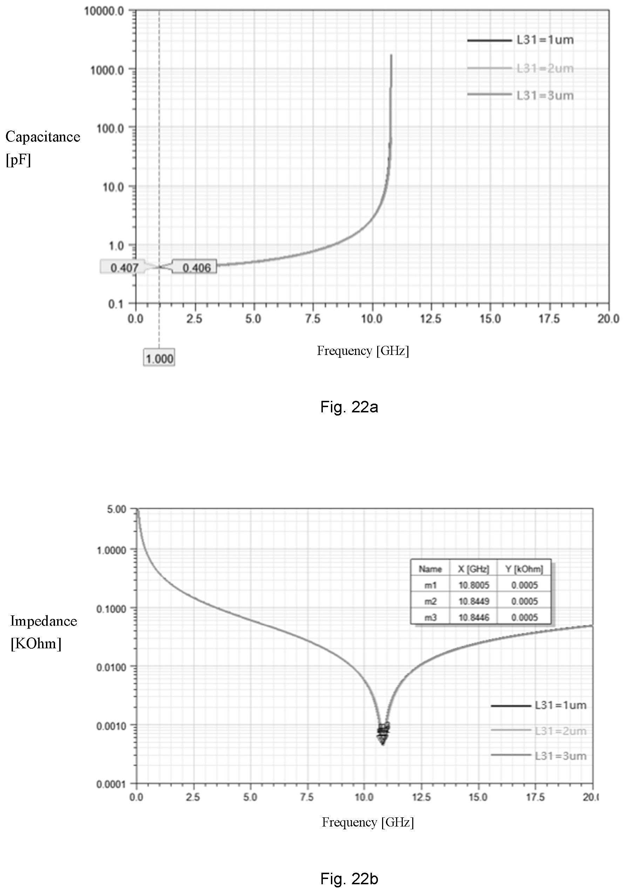

Referring to FIGS. 22a and 22b, the values of L₃₁ are selected as 1 µm, 2 µm, and 3 µm respectively, and other variables remain unchanged. By simulating the capacitance and impedance of the silicon capacitor formed by the silicon capacitor electrode structure composed of columnar units with different values of L₃₁, it is found that the change in the value of L₃₁ has little effect on the capacitance density and impedance.

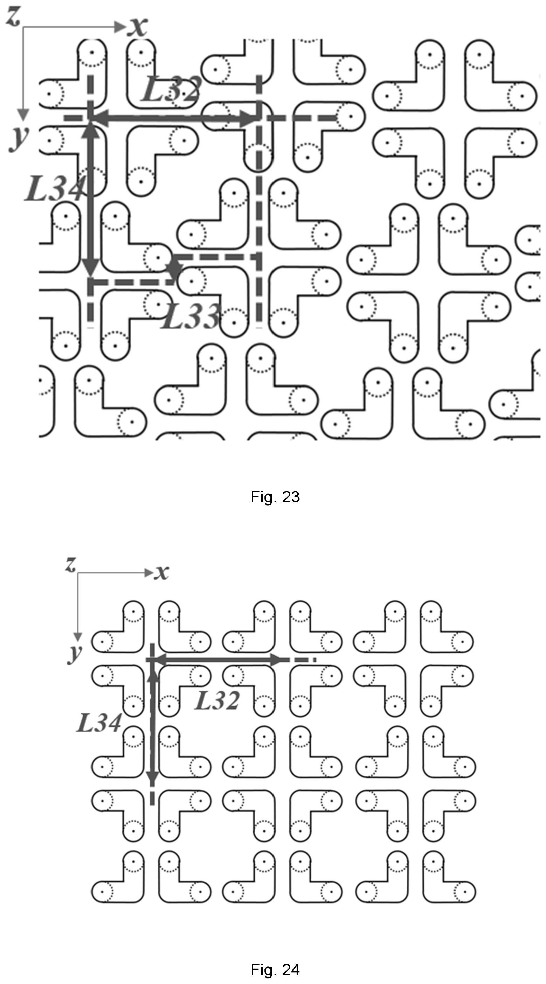

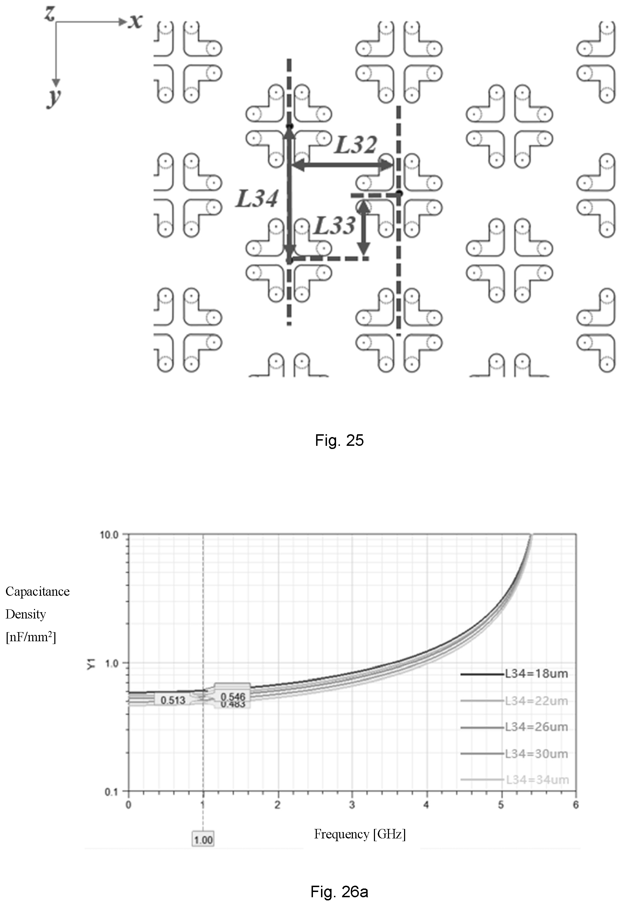

Referring to FIGS. 20, 23 to 25, depending on the different values of L₃₁, L₃₂, L₃₃, and L₃₄, the distribution density of the columnar unit 20 in the silicon capacitor electrode structure is different. When the values of L₃₁, L₃₂, L₃₃, and L₃₄ are small, the silicon capacitor electrode structure shown in FIG. 20 is formed, and the columnar units 20 on the substrate 10 are distributed relatively densely. As the values of L₃₁, L₃₂, L₃₃, and L₃₄ increase, the silicon capacitor electrode structure shown in FIG. 23 is formed, and the distribution of columnar units 20 on the substrate 10 becomes relatively sparse. On this basis, when the value of L₃₃ is 0, a silicon capacitor electrode structure as shown in FIG. 24 is formed, and at this time, the distribution of columnar units 20 on the substrate 10 is already quite sparse, to ensure the columnar units 20 not in contact with each other. When the values of L₃₁, L₃₂, L₃₃, and L₃₄ are large, the silicon capacitor electrode structure shown in FIG. 25 is formed, and the distribution of columnar units 20 on the substrate 10 is very sparse.

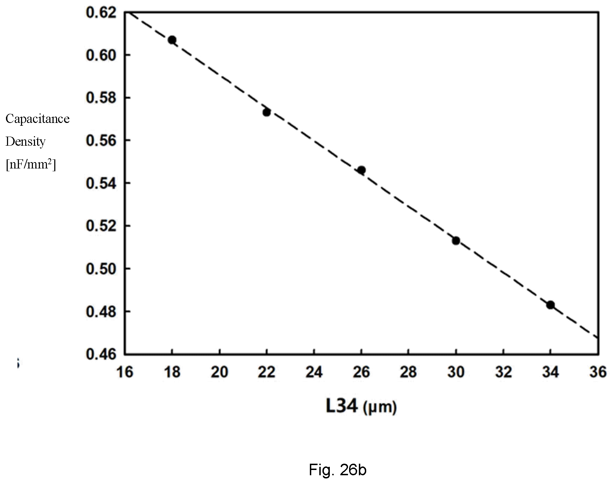

Referring to FIGS. 26a and 26b, the values of L₃₄ are selected as 18 µm, 22 µm, 26 µm, 30 µm, and 34 µm, respectively, while all other variables remain unchanged. The capacitance of the silicon capacitor formed by the columnar units with different L₃₄ was simulated, and the capacitance density was calculated for different L₃₄. The results are as follows: C_{densityL34=18um} = 0.607nF/mm²; C_{densityL34 = 22 µm} = 0.573 nF/mm²; C_{densityL34 = 26 µm} = 0.546 nF/mm²; C_{densityL34} = 30 _{µm} = 0.513 nF/mm²; C_{densityL34} = _{34 µm} = 0.483 nF/mm².

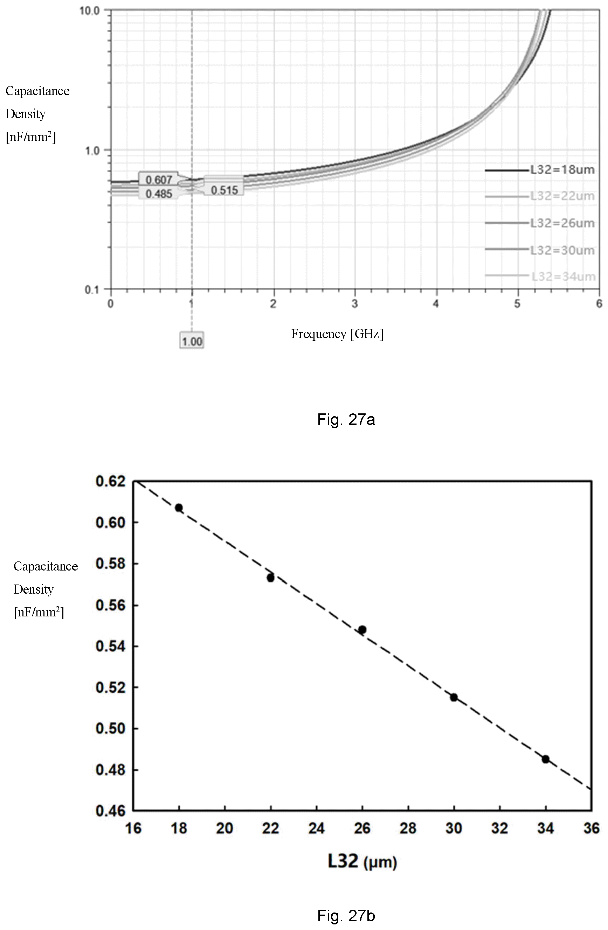

Referring to FIGS. 27a and 27b, the values of L₃₂ are selected as 18 µm, 22 µm, 26 µm, 30 µm, and 34 µm, respectively, while all other variables remain unchanged. The capacitance of the silicon capacitor formed by the columnar units with different L₃₂ was simulated, and the capacitance density was calculated for different L₃₂. The results are as follows: C_{densityL32=18um} = 0.607nF/mm²; C_{densityL32} = 22 _{µm} = 0.573 nF/mm²; C_{densityL32} = 26 _{µm} = 0.548 nF/mm²; C_{densityL32} = 30 _{µm} = 0.515 nF/mm²; C_{densityL32} = _{34 µm} = 0.485 nF/mm².

Therefore, it can be concluded that the smaller the values of L₃₄ and L₃₂, the greater the capacitance density.

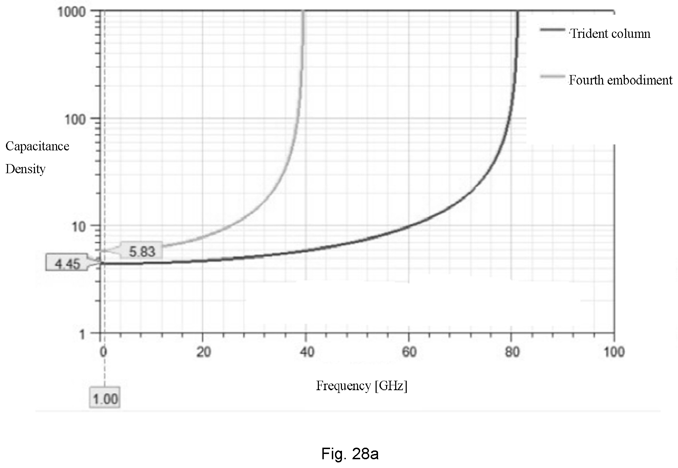

FIG. 28a is a capacitance density simulation diagram of the silicon capacitor electrode structure in the fourth embodiment shown in FIG. 20 of the present invention and the electrode structure of the arrayed trident column model in the prior art shown in FIG. 30. It can be seen from the figure that C fourth embodiment = 5.83 nF/mm²@1 GHz, C trident column = 4.45 nF/mm²@1 GHz.

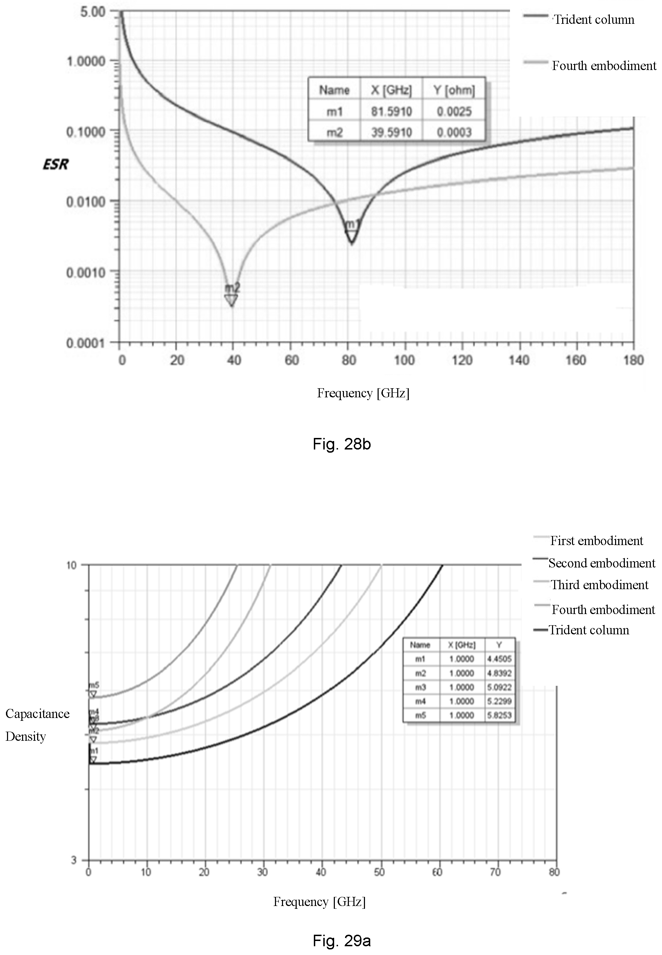

FIG. 28b is a normalized ESR simulation diagram of the silicon capacitor electrode structure shown in FIG. 20 of the fourth embodiment of the present invention and the electrode structure of the arrayed trident column model shown in FIG. 30 of the prior art. It can be seen from the figure that ESR_{fourth embodiment} = 0.3mohm@SRF, ESR trident column = 2.5mohm@SRF.

In the above four implementation methods, the Random Path Identical Dielectric (Resistance) Model and the Random Conductive Path Percolation Model are used for analysis. The columnar units 20 in the silicon capacitor electrode structure are arranged in a periodic distribution. The higher the distribution density of the columnar units, the larger the surface area of the electrode structure, and the higher the capacitance of the prepared capacitor. Additionally, the more uniform the channels formed between adjacent columnar units, the larger and more stable the capacitance value becomes, the lower the equivalent series resistance, and the longer the service life.

FIG. 29a shows a capacitance density simulation diagram of the silicon capacitor electrode structure in the first, second, third, and fourth embodiments of the present invention and the electrode structure of the arrayed trident column model in the prior art shown in FIG. 30. It can be seen from the figure that C _{first embodiment} = 4.84 nF/mm²@1 GHz, C _{second embodiment} = 5.23 nF/mm² @ 1 GHz, C _{third} embodiment = 5.09 nF/mm² @ 1 GHz, C _{fourth} embodiment = 5.83 nF/mm² @ 1 GHz, and C _{trident column} = 4.45 nF/mm² @ 1 GHz.

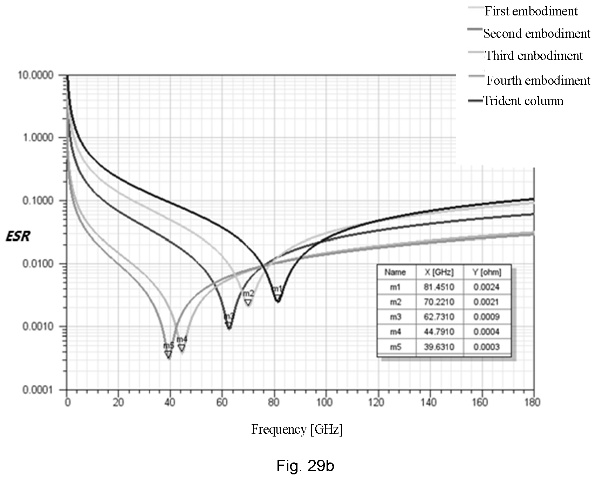

FIG. 29b shows the normalized ESR simulation diagram of the silicon capacitor electrode structure in the first, second, third, and fourth embodiments of the present invention and the electrode structure of the arrayed trident model in the prior art shown in FIG. 30. It can be seen from the figure that ESR _{first embodiment} = 2.1 mohm@SRF, ESR second embodiment = 0.9mohm@SRF, ESR _{third embodiment} = 0.4 mΩ @ SRF, ESR _{fourth embodiment} = 0.3 mΩ @ SRF, and ESR _{trident column} = 2.4 mΩ @ SRF.

It can be concluded that the silicon capacitor formed by the silicon capacitor electrode structure in this invention has a higher capacitance per unit area and a lower equivalent series resistance than the silicon capacitor formed by the electrode structure of the traditional trident column model. Additionally, it can be seen from the above figures that the silicon capacitor structure formed by the columnar units composed of four columns has a higher capacitance per unit area and lower equivalent series resistance than the silicon capacitor structure formed by the columnar units composed of three columns.

It is understood that a silicon capacitor structure can be obtained by forming subsequent layer structures (using conventional methods) on the first surface of the substrate of the silicon capacitor electrode structure described above and on the outer surface of the columnar unit. Since the formation of subsequent layer structures is not the focus of this application, it will not be described in detail here.

Compared with the prior art, the silicon capacitor electrode structure according to the embodiment of the present invention distributes the columnar units on the substrate and arranges the columns within each columnar unit in a reasonable way, which can increase the surface area of the electrode in a limited space, improve the capacitance of the capacitor, and enable it to store more charge. Moreover, while maximizing the surface area of the electrode structure, the structural stability is improved and the equivalent series resistance is reduced to meet application requirements.

The silicon capacitor electrode structure according to the embodiment of the present invention reduces the accumulation of electrons on the outer peripheral surface through the special shape of the columns. Meanwhile, the special arrangement of the columns and columnar units further reduces the equivalent series resistance (ESR) of the silicon capacitor electrode structure.

The silicon capacitor electrode structure according to the embodiment of the present invention increases the surface area by arranging columns and columnar units composed of columns, thereby reducing the volume of the capacitor while maintaining the capacitance unchanged, which is very important for integration into small electronic devices, enabling higher capacitance in a limited space.

The silicon capacitor electrode structure according to the embodiment of the present invention can improve energy density. Since the energy density of a capacitor is related to its capacitance and operating voltage, the increment of the capacitance allows more energy to be stored in the same volume. The silicon capacitor electrode structure of the present embodiment increases the surface area of the electrodes in the same space and improves the capacitance of the capacitor by arranging columns and columnar units composed of columns.

The silicon capacitor electrode structure according to the embodiment of the present invention can further improve performance and stability. The periodically distributed columnar units can provide a uniform electric field distribution, which helps to improve the performance and stability of the capacitor. A uniform electric field distribution helps reduce the leakage current of the capacitor, improve insulation performance, and lower losses. The periodically distributed columnar units can be achieved through precise manufacturing processes, enhancing the consistency of the manufacturing process. This helps reduce performance variations between capacitors and improve manufacturing controllability.

The silicon capacitor electrode structure according to the invention improves mechanical stability and enhances heat dissipation performance. The periodic distribution of the columnar units provides better mechanical stability. This is particularly important for capacitors used in environments subject to vibration or mechanical stress. The periodic distribution of the columnar units improves the heat dissipation performance of the capacitor, as the gaps between the units facilitate air flow and reduce the operating temperature of the capacitor.

According to the silicon capacitor electrode structure of the embodiment of the present invention, multiple columnar units are periodically arranged through a random path identical dielectric (resistance) model, which makes it easier to obtain information about the distribution of conductive paths and charge transfer behavior in the silicon capacitor electrode structure.

According to the silicon capacitor electrode structure of the embodiment of the present invention, by simulating and analyzing the periodic arrangement of multiple columnar units using a random conductive path percolation model, and simulating the equivalent random parallel resistance of the capacitor 3D structure, a better design of the 3D morphology and prediction of the capacitor ESR can be obtained.

The foregoing description of specific exemplary embodiments of the present invention is provided for illustrative and exemplary purposes. These descriptions are not intended to limit the invention to the precise form disclosed, and it will be apparent to those skilled in the art that numerous modifications and changes may be made in accordance with the teachings herein. The purpose of selecting and describing exemplary embodiments is to explain the specific principles of the invention and their practical application, thereby enabling those skilled in the art to practice and utilize various exemplary embodiments of the invention and various selections and modifications. The scope of the present invention is intended to be defined by the claims and their equivalents.

## Claims

1. A silicon capacitor electrode structure, comprising:
a substrate having a first surface; and
a columnar unit array formed on the first surface of the substrate and comprising multiple columnar units distributed periodically , each columnar unit being composed of multiple columns and the adjacent columns not in contact with each other, wherein each columnar unit includes a first main portion located in the center thereof and two support leg portion portions extending along a radial direction from the first main portion, and wherein an angle α₁ is formed between the two support leg portions.

2. The silicon capacitor electrode structure as claimed in claim 1, wherein the angle α₁ between the two support leg portions is in the range of 0°<α₁<180°.

3. The silicon capacitor electrode structure as claimed in claim 1, wherein extension lengths of the support leg portions are same.

4. The silicon capacitor electrode structure as claimed in claim 1, wherein one support leg portion extends in an arc shape to the other support leg portion on a side wall surface at the angle α₁.

5. The silicon capacitor electrode structure as claimed in claim 1, wherein each support leg portion includes a second main portion and a connecting portion, and the connecting portion connects the second main portion and the first main portion;
wherein the first main portion is formed as a cylinder with a diameter of R₁, the second main portion is formed as a cylinder with a diameter of R₂, and the connecting portion has a length R₃ perpendicular to a line connecting a center point of the first main portion and a center point of the second main portion, wherein R₁ = R₂ = R₃.

6. The silicon capacitor electrode structure as claimed in claim 1, wherein each columnar unit comprises two identical columns, and one of the columns has a support leg portion coinciding with an angle bisector of an angle α₁ of another column.

7. The silicon capacitor electrode structure as claimed in claim 6, wherein:
a distance between the support leg portion coinciding with the angle bisector and the first main portion of another column is L₁₁;
in a lateral direction, a lateral distance between the adjacent columnar units is L₁₂, and a longitudinal offset distance between the adjacent columnar unit is L₁₃;
in a longitudinal direction, a longitudinal distance between the adjacent columnar units is L₁₄; and
L₁₁, L₁₂, and L₁₄ are all greater than 0, and L₁₃ is greater than or equal to 0.

8. The silicon capacitor electrode structure as claimed in claim 6, wherein in a longitudinal direction, a support leg portion of one column in the columnar unit is coincident with an angle bisector of an angle α₁ of the column in an adjacent columnar unit.

9. The silicon capacitor electrode structure as claimed in claim 1, wherein the columnar unit comprises three identical columns, the three angles α₁ of the three columns are arranged in a ring shape outward, and the three columns form a pattern with a three-fold rotational symmetry axis.

10. The silicon capacitor electrode structure as claimed in claim 9, wherein each support leg portion of each column is parallel to the support leg portions of the adjacent columns.

11. The silicon capacitor electrode structure as claimed in claim 10, wherein:
a distance between adjacent columns is L₂₁;
in a lateral direction, a lateral distance between the adjacent columnar units is L₂₂, and a longitudinal offset distance between the adjacent columnar units is L₂₃;
in a longitudinal direction, a longitudinal distance between the adjacent columnar units is L₂₄; and
L₂₁, L₂₂, L₂₃, and L₂₄ are all greater than 0.

12. The silicon capacitor electrode structure as claimed in claim 9, wherein a structure of one column in the columnar units in which the angle of the column is directed downward, is defined as a forward-facing columnar unit, and the columnar unit array is entirely composed of the forward-facing columnar units.

13. The silicon capacitor electrode structure as claimed in claim 12, wherein the support leg portions of one column in one columnar unit are correspond to sides of one column in the adjacent columnar unit.

14. The silicon capacitor electrode structure as claimed in claim 9, wherein a structure of one column in the columnar units, in which the angle of the column is directed downward, is defined as a forward-facing columnar unit; a structure of one column in the columnar units, in which the angle of the column is directed upward, is defined as a reverse-facing columnar unit; the columnar unit array is composed of the forward-facing columnar units and the reverse-facing columnar units arranged in combination.

15. The silicon capacitor electrode structure as claimed in claim 1, wherein each columnar unit comprises four identical columns, the four angles α₁ of the four columns are arranged in a ring shape outward, and the four columns form a pattern with a four-fold rotational symmetry axis.

16. The silicon capacitor electrode structure as claimed in claim 15, wherein each support leg portion of each column is parallel to the support leg portions of the adjacent columns.

17. The silicon capacitor electrode structure as claimed in claim 16, wherein:
a distance between adjacent columns is L₃₁;
in a lateral direction, a lateral distance between the adjacent columnar units is L₃₂, and a longitudinal offset distance between the adjacent columnar units is L₃₃;
in a longitudinal direction, a longitudinal distance between the adjacent columnar units is L₃₄; and
L₃₁, L₃₂, L₃₃, and L₃₄ are all greater than 0.

18. A silicon capacitor comprising a silicon capacitor electrode structure as claimed in any one of claims 1-17.
